# EUROPEAN PATENT APPLICATION

(11) **EP 3 937 375 A1**
(43) Date of publication of application: **12.01.2022**
(21) Application number: 20185034.4
(22) Date of filing: 09.07.2020
(51) Int. Cl.: H03F 1/08, H03F 1/42, H03F 1/56, H03F 3/195, H03F 3/21, H03H 7/38

(54) **DEVICE INCLUDING POWER TRANSISTOR AND DC FEED PATH AND METHOD**

(71) Applicant: Infineon Technologies AG, 85579 Neubiberg (DE)
(72) Inventor: CANNING, Timothy, 93049 Regensburg (DE); BRECH, Helmut, 93138 Lappersdorf (DE)
(74) Representative: Sticht, Andreas

(57) **Abstract**

A device (10) is provided including a power transistor (11) at an output node (12), which is coupled to a load terminal of the power transistor (11). A DC feed path (17) is also provided. One or more discrete capacitors (14, 15) are coupled between the DC feed path and a reference potential. A first capacitor (14) of the one or more discrete capacitors (14, 15) which is closest to the output node is a trench capacitor device.

## Description

### BACKGROUND

The present invention relates to devices including a power transistor and a DC feed path and to corresponding methods.

Radio frequency (RF) power amplifier circuits for example for wireless infrastructure applications must meet strict linearity requirements. These requirements may imply that a signal is allowed to propagate in the circuit only in a tightly controlled frequency range.

Power amplifiers are based on one or more power transistors. In many implementations, an output terminal of such a transistor is coupled to an output node of the power amplifier or of a respective stage of the power amplifier. Additionally, in many applications a DC (direct current) feed path is coupled to this output node.

To meet the above-mentioned requirements, filter components are implemented which ideally present a short circuit to the transistor (thus allowing no voltage swing at the output node) at every frequency other than DC (frequency 0 Hz) and a radio frequency band of interest, for example the band in which signals are to be amplified.

The accuracy or quality of this filtering has to be balanced against available area and performance.

For example, some conventional solutions use large high power transistors for amplification and large external high voltage capacitors for filtering. Such capacitors require corresponding space, which may not always be available. In newer approaches for 5G (fifth generation mobile communication) analog front-end modules which are subject to space constraints (for example height of total module smaller than 1.5 mm) the size of such capacitors on an printed circuit board (PCB) is limited. Therefore, smaller capacitors may need to be used, which, however, may adversely affect the quality of the filtering.

### SUMMARY

A device as defined in claim 1 and a method as defined in claim 13 are provided. The dependent claims define further embodiments.

According to an embodiment, a device is provided, comprising: a power transistor,
an output node coupled to a load terminal of the power transistor,
a DC feed path coupled between a DC feed node and the output node,
one or more discrete capacitors coupled between the DC path feed path and reference potential, wherein a first capacitor of the one or more discrete capacitors which is closest to the output node is a trench capacitor device.

According to another embodiment, a method is provided, comprising:
providing an output signal at an output node by controlling a power transistor,
providing a DC feed to the output node via a DC feed path, and
providing a filtering using one or more discrete capacitors coupled between a DC feed path for providing the DC feed and a reference potential, wherein a first capacitor of the one or more discrete capacitors which is closest to the output node is a trench capacitor device.

The above summary is merely a short overview over some features of some embodiments and is not to be construed as limiting in any way, as other embodiments may include other features than the ones explicitly given above.

### BRIEF DESCRIPTION OF THE DRAWINGS

Fig. 1 is a circuit diagram of a device according to an embodiment.
Fig. 2 is a schematic perspective view of a trench capacitor device usable in some embodiments.
Fig. 3 is a circuit diagram illustrating a device according to an embodiment.
Fig. 4 shows simulation results for an example implementation of the device of Fig. 3 together with a simulation result for a conventional device.
Fig. 5 is a circuit diagram illustrating a device according to an embodiment.
Figs. 6 and 7 show simulation results for an implementation of the device of Fig. 5 together with simulation results for a conventional device.
Fig. 8 is a flow chart illustrating a method according to some embodiments.

### DETAILED DESCRIPTION

In the following, various embodiments will be described in details referring to the attached drawings. These embodiments are given by way of example only and are not to be construed as limiting the scope of the present application. For example, while embodiments may be described as comprising a plurality of features (components, circuit elements, method acts or events etc.), in other embodiments some of these features may be omitted or may be replaced by alternative features. In addition to the features explicitly shown and described, other features may be provided, for example features used in conventional radio frequency power amplifiers and methods for operating the same. As such features are conventional, they will not be described explicitly herein.

Features from different embodiments may be combined unless noted otherwise. Modifications or variations described with respect to one of the embodiments may also be applied to other embodiments and will therefore not be described repeatedly.

Connections and couplings described herein refer to electrical connections or couplings unless noted otherwise. Such connections or couplings may be modified, for example by adding additional elements or removing elements, as long as the general function of the connection or coupling, for example to transmit a signal or to provide a filtering, is essentially maintained.

In some embodiments, transistors, in particular power transistors are used. A power transistor is a transistor which may be used with relatively high voltages or currents and may be used for example in power amplifiers. Such transistors may comprise a plurality of transistor cells. Transistors will be described herein as including a control terminal and two load terminals. In case of a field-effect transistor (FET) like a MOSFET, the control terminal is the gate terminal, and the load terminals are the source and drain terminals. In case of a bipolar junction transistor (BJT), the control terminal is the base terminal, and the load terminals is the emitter and collector terminals. In case of an insulated gate bipolar transistor (IGBT), the control terminal is the gate terminal, and the load terminals are the collector and emitter terminals. While field-effect transistors will be used in some of the embodiments discussed below, in other embodiments also other kinds of transistors may be used.

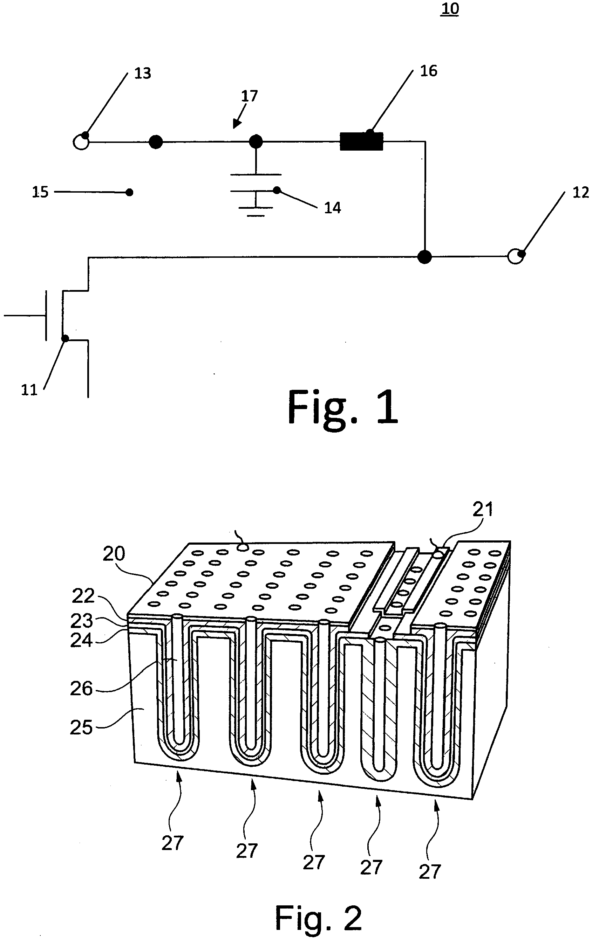

Embodiments herein use trench capacitor devices. Trench capacitor devices are capacitors which are formed in one or more trenches. Trenches are generally recesses in a substrate, in particular a semiconductor substrate. Such trenches are used for various purposes in semiconductor devices manufacture, for example for forming insulations between areas on a chip, or for forming devices within trenches. Trenches have a typically elongated shape (length larger than width) and may be formed by various etching techniques. In trench capacitors, as will be described further below in more detail with respect to Fig. 2, two electrodes of a capacitor are formed separated by a dielectric material. By forming capacitors in one or more trenches, a high capacitance value may be obtained in a comparatively small area. Two or more trenches may be formed adjacent to each other to form the trench capacitor device. By forming the trenches close to each other, trench capacitor devices with low equivalent series inductance (ESL), for example less than 75 pH, less than 30 pH, less than 15 pH or even less, may be formed, and/or a correspondingly low equivalent series resistance (ESR). Connections between trenches may have inductances below 10 pH. A distance between trenches may depend on implementation, and may for example depend on a type of metallization (thick metallization, thin metallization) used.

A discrete capacitor, as used herein, is a capacitor which is intentionally formed by design to provide a certain capacitance value. It may be integrated in an integrated chip, for example as a trench capacitor device, or may be formed as a separate element. It is to be distinguished from parasitic capacitances which occur in circuits, for example capacitances inherent to transistors like drain source capacitance of a field-effect transistor, which is not intentionally formed as a capacitor, but inherent in the transistor design.

Turning now to the figures, Fig. 1 is a circuit diagram of a device 10 according to an embodiment. Device 10 may be included in a power amplifier, form a power amplifier or form a stage of a power amplifier.

Device 10 comprises a power transistor 11. A first load terminal of power transistor 11, for example a drain terminal, is coupled to an output node 12, and the respective other load terminal (for example source) may be coupled to a reference potential like ground or VSS (not shown in Fig. 1). In a power amplifier application, a signal to be amplified, for example a radio frequency signal, may then be applied between the control terminal (for example gate terminal) and the load terminal which is coupled to a reference potential, for example as gate source voltage, causing an amplified signal to be provided at output node 12. However, this is only a simple example, and power transistor 11 may be used for example in any conventional power amplifier layouts or also in other applications. In communication applications, output node 12 may for example be coupled to an antenna.

A DC feed path 17 is coupled to output node 12. A DC voltage may be applied at a DC feed node 13.

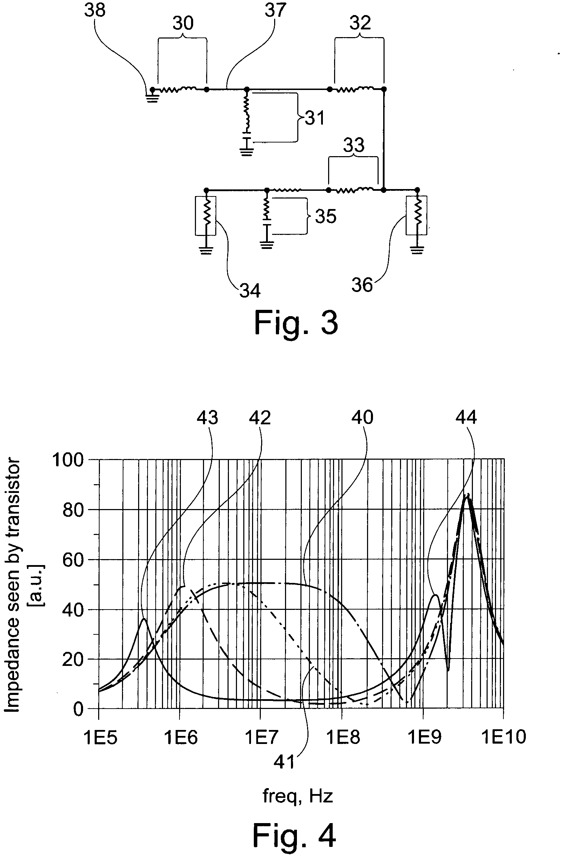

DC feed path 17 includes a matching impedance 16, typically an inductor which may be formed by a conductive path of a certain length, which is dimensioned to resonate out (also referred to as compensating or absorbing) a capacitance between the load terminals of power transistor 11 (for example drain source capacitance of power transistor 11). Between DC feed node 13 and output node 12, and in the embodiment of Fig. 1 more precisely, between DC feed node 13 and matching impedance 16, one or more capacitor 14, 15 are coupled between DC feed path 17 and a reference potential, for example ground. A first capacitor 14 which is closest to output node 12, and, in the embodiment of Fig. 1 closest to matching impedance 16, is a trench capacitor device. As will be explained further below using examples with reference to Figs. 3 to 7, through the use of a trench capacitor high capacitance values may be obtained while requiring little space and offering small equivalent series inductance, which may help to fulfill specifications for suppressing signals outside DC and a radio frequency band for which device 10 is intended to be used (for example a frequency band in which signals are to be amplified). One or more second capacitors like capacitor 15 may optionally be provided to improve filtering characteristics. Capacitor 15 may be implemented as a trench capacitor device, but may also be implemented in any conventional manner as a discrete capacitor.

Fig. 2 shows an example implementation of a trench capacitor device which is usable in embodiments discussed herein, for example as first capacitor 14 of Fig. 1. The trench capacitor device of Fig. 2 is formed in a plurality of trenches 27, which are formed in a semiconductor substrate 25. In some implementations, semiconductor substrate 25 may be a lowly N-doped (N-) silicon substrate.

A first electrode 24 is formed on substrate 25 and in trenches 27 as shown. In some implementations, first electrode 24 may be a highly N-doped silicon layer. A dielectric layer 23 is formed on top of first electrode 24. Dielectric layer 23 may be a silicon dioxide layer or a silicon nitride layer. These dielectrics are used in standard silicon processing and therefore such a layer may be formed using standard processes. Compared to ceramic capacitors used in some conventional approaches which employ aluminum oxide

(Al₂O₃) as a dielectric material, silicon dioxide has a significantly higher breakdown strength (about 500 kV/mm for SiO₂, silicon dioxide, about 15 kV/mm for Al₂O₃). This enables obtaining of higher capacitances, as the capacitance value C is given by (*ε · A*)/*d,* wherein *ε* is the dielectric constant, *A* is the area of the capacitor and *d* is the distance between the capacitor electrodes. With a higher breakdown strength of the material used, the distance *d* may be reduced for the same voltages and areas, thus increasing C.

On dielectric material 23, a second electrode 22, for example of highly N-doped (N+) polysilicon, is provided. An insulating material 26, for example again a dielectric, is provided in the trenches for separation. Second electrode 22 is contacted by a first metal top electrode 20. First electrode 24 is contacted by a second metal top electrode 21 as shown.

In this configuration, a small distance between trenches 27 is obtained, such that capacitor devices with high capacitance values and low equivalent series inductance (ESI) and low equivalence series resistance (ESR) may be provided. For example, capacitance values of 1 nF or more, for example more than 5 nF or more than 10 nF, may be obtained, while equivalent series inductance (ESL) is below 30 pH, for example below 20 pH or below 10 pH, and equivalent series resistance is also low. Such values cannot be obtained in a small space by conventional capacitors like ceramic capacitors. Capacitances between the trenches, also referred to as intertrench capacitances, may be below 10 pH.

Further embodiments and effects of using such trench capacitor devices will now be explained referring to Figs. 3 to 7.

In order to avoid repetitions, the embodiments of Figs. 3 to 7 will be explained referring to explanations already made with respect to Figs. 1 and 2.

Fig. 3 is a circuit diagram illustrating a device according to a further embodiment. Fig. 3 represents a network coupled to a power transistor like power transistor 11 of Fig. 1. The power transistor itself is not shown in Fig. 3, but a series connection 35 of a resistor and a capacitor represents a drain source capacitance of the power transistor together with a corresponding resistance. A termination 34 to ground at the transistor side of the device of Fig. 3 serves simulation purposes. A series connection 33 of resistor and inductor represents a parasitic package inductance and parasitic drain inductance of the power transistor. A termination 36 at an output node again serves simulation purposes.

Furthermore, a DC feed path 37 corresponding to DC feed path 17 of Fig. 1 is provided. At a DC feed node end, for simulation purposes, DC feed path 37 is coupled to ground at 38. A series connection 30 of resistor and inductor is a simple model of a cable or printed circuit board trace to a DC supply, from which a DC feed voltage is supplied. A series connection 31 of resistor, inductor and capacitor represents a trench capacitor device coupled between DC feed line 37 and ground. The capacitance of series connection 31 corresponds to the capacitance of the trench capacitor device, the resistance corresponds to the equivalent series resistance of the trench capacitor device, and the inductance corresponds to the equivalent series inductance of the trench capacitor device. Therefore in the embodiment of Fig. 3 a single capacitor (corresponding to only capacitor 14 of Fig. 1) is provided. A series connection 32 of resistor and inductor provides a matching impedance for resonating out the drain source capacitance of the power transistor, corresponding to matching impedance 16 of Fig. 1.

The embodiment of Fig. 3 was simulated for specific values. Results of the simulation are shown in Fig. 4. The following values were used for simulation. For series connection 30, resistance R=500 mΩ, and inductance L=2µH; for series connection 32, R=150 mΩ and L selected to resonate out the drain source capacitance of the transistor, for series connection 33 R=150 mΩ and L=150 pH, and for series connection 35 R=50 mΩ and C corresponding to the drain source capacitance of the transistor. *L* = 1/2 · *ω_{Res}* · *Cds*), where *Cds* is the drain source capacitance. For the simulation, the drain source capacitance was set to 4 pF, the resonance angular frequency *ω_{Res}* was set to *2* · *π · fres,* where the resonance frequency *fres* is 3.5 GHz. For series connection 31, the equivalent series inductance was set to 6.6 pH, and the equivalent series resistance to 10 mΩ. It is to be understood that these values were selected to give an impression of the property of some embodiments, but are not to be construed as limiting, as depending on implementation and requirements these values may vary.

Simulation results are shown in Fig. 4. Fig. 4 illustrates an impedance as seen by the power transistor over frequency. A curve 40 illustrates simulation results for a trench capacitance (capacitance of series connection 31) of 0.1 nF, a curve 41 shows results for the trench capacitance of 1 nF, and a curve 42 shows results for a trench capacitance of 10 nF. Such capacitances may be realized using trench capacitor devices with comparatively small space requirements and low equivalent series inductance and resistance compared to conventional solutions.

For comparison purposes, a conventional device using two conventional capacitors has been simulated, where the results are shown in a curve 43. For the conventional device, a capacitor for improving behavior at lower frequencies (also referred to CBB capacitor) having a capacitance value of 100 nF, an equivalent series inductance of 350 pH and an equivalent series resistance of 350 mΩ was provided, together with a capacitor for higher frequency behavior having a capacitance value of 20 pF and an equivalent series inductance of 14 pH. For this second capacitor, due to conventional implementation techniques, even for a considerably lower capacitance like the trench capacitor, a higher equivalent series inductance results. This for example leads to a resonance peak at 44 in Fig. 4, which may lead to undesired behavior.

As can be seen, for all capacitance values of the trench capacitor, this resonant peak 44 disappears. Also, in particular for capacitance values of 1 nF (curve 41) and even more for a capacitance value of 10 nF (curve 42), a behavior at mid frequencies (about 1*10⁸ Hz and slightly above) is improved compared to the conventional solution, resulting in a lower impedance, which corresponds to the above-mentioned short circuit for intermediate frequencies.

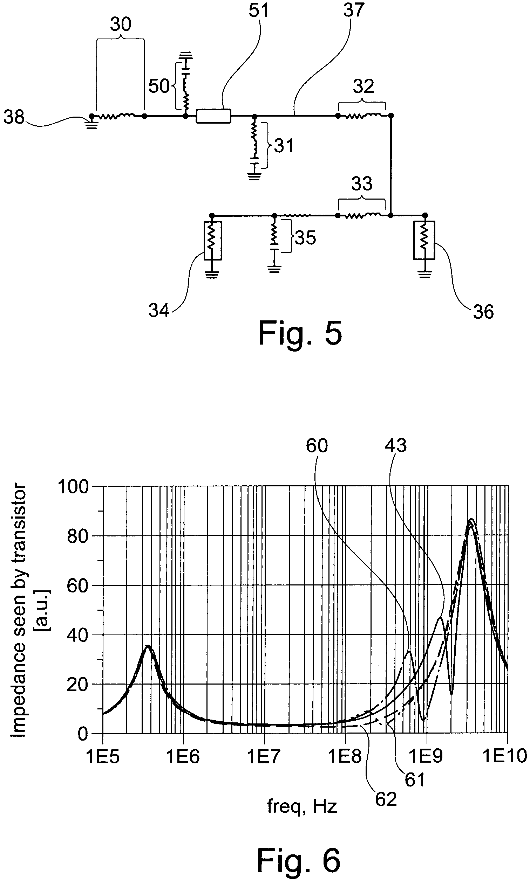

In some embodiments, for improved low frequency behavior, one or more additional second capacitors may be used. A corresponding embodiment is illustrated in Fig. 5. The embodiment of Fig. 5 is a modification of the embodiment of Fig. 3, and components already present in the embodiment of Fig. 3 will not be described again in detail.

In addition to the components already described referring to Fig. 3, a series connection 50 representing a second capacitor (for example second capacitor 15 of Fig. 1) is provided. This capacitor may be implemented in a conventional manner, for example as an external ceramic capacitor. Series connection 50 comprises a capacitor representing the capacitance, an inductance representing the equivalent series inductance and a resistance representing the equivalent series resistance of the second capacitor. As can be seen in Fig. 5, the trench capacitor represented by series connection

31 is closer to the output node and closer to the series connection 32 than the second capacitor represented by series connection 50. An impedance 51 is represented between series connections 50 and 31 as shown, which represents an impedance of the DC feed path 37 between the series connections 50, 31, and may correspond to an impedance by a minimal trace between two traces placed sequentially on a printed circuit board. The second capacitor corresponds to the above-mentioned CBB capacitor for the conventional case.

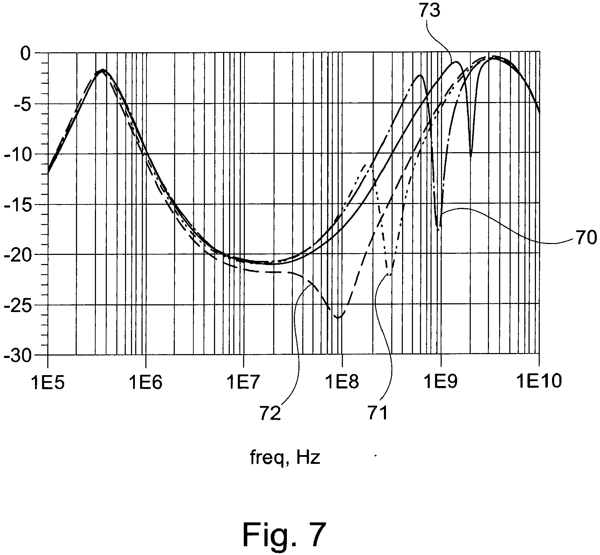

Figs. 6 and 7 show simulation results for the device of Fig. 5. For the components already present in Fig. 3, the same values were used for simulation. For series connection 50, i.e. the second capacitor, similar to the conventional case discussed with reference to Fig. 4, a capacitance value of 100 nF, an equivalent series inductance of 350 pH and an equivalent series resistance of 350 mΩ was used. The capacitance value is higher than for the trench capacitor device represented by series connection 31, but equivalent series resistance and equivalent series inductance are also significantly higher. It should be noted that due to the reduced space requirements of a trench capacitor, a high capacitance may be provided in series connection 31 compared to the conventional case with two conventional capacitors without requiring additional space. The capacitance of series connection 50 in other embodiments may extend to the microfarad range. A resistance of impedance 51 was set to 20 Ω at 1 GHz.

Fig. 6 shows simulation results for the impedance seen the transistor (similar to the simulation of Fig. 4) and Fig. 7 shows simulation results for the transmission from the transistor to the output node, for example to an antenna coupled to the output node.

In Fig. 6, curve 43 again shows the conventional case. Curve 60 shows results for a trench capacitance value of 0.1 nF, curve 61 shows results for a trench capacitance of 1 nF, and a curve 62 shows the results for a trench capacitance of 10 nF. As can be seen, the behavior for lower frequency is similar for all cases due to the second capacitor provided, but the behavior for high frequencies is improved compared to the conventional peak through the use of the trench capacitor device having high capacitance value and low equivalence series inductance and resistance in particular for the case of 10 nF, where the resonance disappears. For lower frequencies, this resonance is at least reduced and shifted to lower frequencies. Furthermore, for some intermediate frequencies a lower impedance may be obtained.

In a similar manner, in Fig. 7 curve 70 shows the result for a trench capacitance of 0.1 nF, curve 71 for 1 nF, 72 for 10 nF and curve 73 for the conventional case. Also here, the behavior at lower frequencies is essentially the same, and the higher frequency behavior may be improved, in particular without a dip in transmission seen in curve 73 in a frequency band of interest in particular for curve 72. Already for a trench capacitance of 1 nF (curve 61) a significant improvement can be seen, shifting the dip in transmission away from a use frequency band for the device, which may for example be above 1x10⁹ Hz.

It is emphasized again that the particular values and simulation results serve only for illustration purposes, and for other embodiments other values may apply.

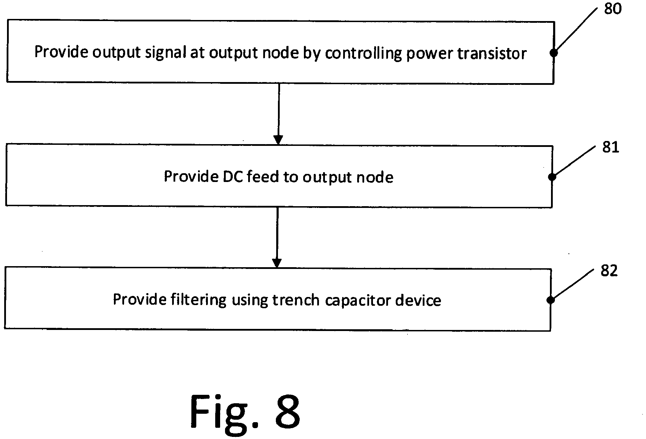

Fig. 8 is a flow chart illustrating a method according to an embodiment. The method of Fig. 1 may be executed by operating the devices discussed above with reference to Figs. 1 to 7, and in order to avoid repetitions the method will be described referring to the previous explanations. However, it is to be understood that the method may also be implemented independently from the specific device implementations shown.

At 80, the method comprises providing an output signal at an output node, for example to an antenna, by controlling a power transistor. For example, by providing a corresponding control signal (for example signal to be amplified) to a gate terminal of power transistor 11 in Fig. 1, a corresponding output signal at output node 12 may be generated.

At 81, the method comprises providing a DC feed to the output node, for example by DC feed path 17 or 37 discussed above.

At 82, the method comprises providing a filtering using a trench capacitor device coupled to the DC feed path closest to the output node compared to optionally present further capacitor devices, for example capacitor device 14 of Fig. 1 or the capacitor device represented by series connection 31 in Figs. 3 and 5. Optionally, the filtering may involve the use of further capacitors like capacitor 15 of Fig. 1 or the second capacitor represented by series connection 50 of Fig. 5, and by matching impedances by matching impedance 16 of Fig. 1 or series connection 32 of Fig. 5.

Some embodiments are defined by the following examples:
Example 1. A device, comprising:
   a power transistor,
   an output node coupled to a load terminal of the power transistor,
   a DC feed path coupled between a DC feed node and the output node,
   one or more discrete capacitors coupled between the DC feed path and a reference potential, wherein a first capacitor of the one or more discrete capacitors which is closest to the output node is a trench capacitor device.
Example 2. The device of example 1, wherein the first capacitor comprises a dielectric material selected from the group comprising silicon nitride or silicon oxide.
Example 3. The device of example 1 or 2, wherein the first capacitor has a total capacitance value of at least 500 pF, for example at least 1 nF, for example at least 5 nF.
Example 4. The device of any one of examples 1 to 3, wherein the first capacitor has an equivalent series inductance of less than 75 pH, for example less than 30 pH or less than 15 pH.
Example 5. The device of any one of examples 1 to 4, wherein the first capacitor is provided in an plurality of trenches, with a capacitance between adjacent trenches of less than 10 pH.
Example 6. The device of any one of examples 1 to 5, wherein the DC feed path further comprises a matching impedance between the first capacitor and the output node, wherein the matching impedance is configured to resonate out a capacitance of the power transistor between the load terminal and a further load terminal of the power transistor. This capacitance may for example be a drain source capacitance in case of a field-effect transistor.
Example 7. The device of any one of examples 1 to 6, wherein the first capacitor is the only discrete capacitor coupling the DC feedback path to ground.
Example 8. The device of any one of examples 1 to 6, wherein the one or more discrete capacitors comprise at least one second capacitor.
Example 9. The device of example 8, wherein the at least one second capacitor has a capacitance value equal to or greater than a capacitance value of the first capacitor.
Example 10. The device of example 8 or 9, further comprising an impedance between the first capacitor and the second capacitor.
Example 11. The device of any one of examples 1 to 10, wherein the trench capacitor device comprises a plurality of trench capacitor elements.
Example 12. The device of example 11, wherein an inductance between adjacent trench capacitor elements is less than 10 pH.
Example 13. A radio frequency amplifier device, comprising the device of any one of examples 1 to 12.
Example 14. A method, comprising: providing an output signal at an output node by controlling a power transistor,
   providing a DC feed to the output node via a DC feed path, performing a filtering using one or more discrete capacitors coupled between the DC feed path and a reference potential, wherein a first capacitor of the one or more discrete capacitors which is closest to the output node is a trench capacitor device.
Example 15. The method of example 14, wherein the one or more discrete capacitors comprise at least one second capacitor.
Example 16. The method of example 14 or 15, wherein the method is performed using the device of any one of examples 1 to 12.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A device (10), comprising:
a power transistor (11),
an output node (12) coupled to a load terminal of the power transistor (11),
a DC feed path (17; 37) coupled between a DC feed node (13) and the output node (12),
one or more discrete capacitors (14, 15; 31, 50) coupled between the DC feed path (17; 37) and a reference potential, wherein a first capacitor (14; 31) of the one or more discrete capacitors (14, 15; 31, 50) which is closest to the output node is a trench capacitor device.

2. The device (10) of claim 1, wherein the first capacitor (14; 31) comprises a dielectric material selected from the group comprising silicon nitride or silicon oxide.

3. The device (10) of claim 1 or 2, wherein the first capacitor (14; 31) has a total capacitance value of at least 500 pF.

4. The device (10) of any one of claims 1 to 3, wherein the first capacitor has an equivalent series inductance of less than 75 pH.

5. The device (10) of any one of claims 1 to 4, wherein the DC feed path (17; 37) further comprises a matching impedance (16; 32) between the first capacitor (14; 31) and the output node (12), wherein the matching impedance (16; 32) is configured to resonate out a capacitance of the power transistor (11) between the load terminal and a further load terminal of the power transistor (11).

6. The device (10) of any one of claims 1 to 5, wherein the first capacitor (14; 31) is the only discrete capacitor coupling the DC feedback path (17; 37) to ground.

7. The device (10) of any one of claims 1 to 5, wherein the one or more discrete capacitors (14, 15; 31, 50) comprise at least one second capacitor (15; 50).

8. The device (10) of claim 7, wherein the at least one second capacitor (15; 50) has a capacitance value equal to or greater than a capacitance value of the first capacitor (14; 31) .

9. The device (10) of claim 7 or 8, further comprising an impedance (51) between the first capacitor (14; 31) and the second capacitor (15; 50).

10. The device of any one of claims 1 to 9, wherein the trench capacitor device comprises a plurality of trench capacitor elements.

11. The device of claim 10, wherein an inductance between adjacent trench capacitor elements is less than 10 pH.

12. A radio frequency amplifier device, comprising the device of any one of claims 1 to 11.

13. A method, comprising:
providing an output signal at an output node (12) by controlling a power transistor (11),
providing a DC feed to the output node (12) via a DC feed path (17; 37),
performing a filtering using one or more discrete capacitors (14, 15; 31, 50) coupled between the DC feed path (17; 37) and a reference potential, wherein a first capacitor (14; 31) of the one or more discrete capacitors (14, 15; 31, 50) which is closest to the output node is a trench capacitor device.

14. The method of claim 13, wherein the one or more discrete capacitors (14, 15; 31, 50) comprise at least one second capacitor (15; 50).

15. The method of claim 13 or 14, wherein the method is performed using the device (10) of any one of claims 1 to 11.
